(19) Europäisches Patentamt
European Patent Office
Office européen des brevets

(11) **EP 4 711 747 A1**

(12) **EUROPEAN PATENT APPLICATION**
published in accordance with Art. 153(4) EPC

(43) Date of publication:
**18.03.2026   Bulletin 2026/12**

(21) Application number: 24810635.3

(22) Date of filing: **17.01.2024**

(51) International Patent Classification (IPC):
**G01N 21/88** (2006.01)     **G01J 3/51** (2006.01)

(52) Cooperative Patent Classification (CPC):
**G01J 3/51; G01N 21/88**

(86) International application number:
**PCT/JP2024/001130**

(87) International publication number:
**WO 2024/241626 (28.11.2024 Gazette 2024/48)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:   **19.05.2023   JP 2023083327**

(71) Applicant: **Hamamatsu Photonics K.K.
Hamamatsu-shi, Shizuoka 435-8558 (JP)**

(72) Inventor: **NAKAMURA, Tomonori
Hamamatsu-shi, Shizuoka 435-8558 (JP)**

(74) Representative: **Hoffmann Eitle
Patent- und Rechtsanwälte PartmbB
Arabellastraße 30
81925 München (DE)**

(54)     **INSPECTION DEVICE AND INSPECTION METHOD**

(57)     An inspection apparatus for inspecting a semiconductor apparatus includes a stage configured to hold the semiconductor apparatus, an LRG filter having a transmission characteristic in which transmittance varies linearly in a predetermined wavelength range and configured to transmit or reflect emitted light generated from the semiconductor apparatus on the basis of the transmission characteristic, an infrared camera configured to capture the light transmitted through the LRG filter to output a transmission image and capture light as emitted light that has arrived without passing through the LRG filter to output a total light amount image, and a computer configured to derive wavelength information about the emitted light on the basis of the transmission image and the total light amount image.

**Fig.1**

Processed by Luminess, 75001 PARIS (FR)

**Description**

**Technical Field**

The present disclosure relates to an inspection apparatus and an inspection method.

Background Art

As a method for analyzing failures of semiconductor apparatuss, a method for detecting emitted infrared light generated from semiconductor apparatuss and analyzing failures of the semiconductor apparatuss on the basis of detection results is known (e.g., Patent Literatures 1 to 3). Patent Literature 1 discloses that emitted infrared light generated from semiconductor apparatuss is captured through a band filter provided within an infrared camera. Patent Literatures 2 and 3 disclose that spectroscopic spectra of emitted infrared light generated from semiconductor apparatuss are acquired using a rotatable diffraction grating.

**Citation List**

**Patent Literature**

> [Patent Literature 1] Japanese Unexamined Patent Publication No. 2016-517970
> [Patent Literature 2] Japanese Unexamined Patent Publication No. 2015-175851
> [Patent Literature 3] Japanese Unexamined Patent Publication No. 2015-203700

**Summary of Invention**

**Technical Problem**

Here, technology described in Patent Literature 1 only provides information that a wavelength of captured emitted infrared light is in a wavelength range of a band filter, and the wavelength resolution is low. Moreover, the technology described in Patent Literature 1 may complicate a process because it is necessary to change a band filter arranged in a vacuum as appropriate with a filter wheel. In technology described in Patent Literature 2, because the spectroscopic spectrum is also acquired as an image along with an image of the emitted infrared light, it is difficult to say that the wavelength is acquired with high accuracy, and if there are a plurality of emitted infrared beams, the issued image and the spectroscopic spectrum may overlap each other. In the inspection of semiconductor apparatus, it is known that emitted hot carrier light such as leaked emitted light and emitted switching light and emitted Si recombination light are generated, and because these have different wavelength characteristics, there is a demand to know the wavelength information about these types of emitted light.

The present disclosure has been made in view of the above circumstances, and an objective of the present disclosure is to provide an inspection apparatus and an inspection method for enabling wavelength information about emitted light generated from a semiconductor apparatus to be acquired with high accuracy and easily.

**Solution to Problem**

An inspection apparatus according to an aspect of the present disclosure is [1] "an inspection apparatus for inspecting a semiconductor apparatus, the inspection apparatus comprising: a stage configured to hold the semiconductor apparatus; an optical filter having a transmission characteristic in which transmittance varies linearly in a predetermined wavelength range and configured to transmit or reflect emitted light generated from the semiconductor apparatus on the basis of the transmission characteristic; an imaging unit configured to capture the light transmitted or reflected by the optical filter to output first image data and capture light as emitted light that has arrived without passing through the optical filter to output second image data; and an analysis unit configured to derive wavelength information about the emitted light on the basis of the first image data and the second image data."

In the inspection apparatus according to the aspect of the present disclosure, the emitted light generated from the semiconductor apparatus is transmitted or reflected by the optical filter in accordance with the wavelength. Also, the wavelength information about the emitted light is derived on the basis of the first image data obtained by capturing the light transmitted or reflected by the optical filter and the second image data obtained by capturing the emitted light that has arrived without passing through the optical filter. Thus, in the inspection apparatus according to the aspect of the present disclosure, because the optical filter is used to transmit or reflect the light according to a wavelength, the first image data is image data according to the wavelength of the light. Moreover, because the first image data is image data obtained by capturing light transmitted or reflected by the optical filter and the second image data is image data obtained by capturing light that has arrived without passing through the optical filter, information about light transmitted through the optical filter and light reflected through the optical filter can be obtained from these image data. Thus, information about the light transmitted or reflected in accordance with the wavelength can be acquired with high accuracy and wavelength information of light can be acquired with high accuracy Furthermore, in this method for acquiring the wavelength information, the wavelength information about the emitted light can be acquired spatially all at once and the wavelength information can be easily acquired because a process for changing a band filter or the like is unnecessary. As described above, the inspection apparatus according to the aspect of the present disclosure can acquire wavelength information about emitted light generated from a semiconductor apparatus with high accuracy and easily.

An inspection apparatus according to an aspect of the present disclosure may be [2] "the inspection apparatus according to [1], wherein the imaging unit may have an image sensor configured to capture the light transmitted or reflected by the optical filter and capture the light as the emitted light that has arrived without passing through the optical filter." According to this image sensor, it is possible to appropriately image desired light.

An inspection apparatus according to an aspect of the present disclosure may be [3] "the inspection apparatus according to [1] or [2], further comprising a switching unit configured to perform a switching operation between a state in which an optical filter is provided on the light path between the semiconductor apparatus and the imaging unit and a state in which no optical filter is provided." According to this configuration, both the first image data and the second image data described above can be appropriately acquired while a switching operation is performed between the presence and absence of the optical filter.

An inspection apparatus according to an aspect of the present disclosure may be [4] "the inspection apparatus according to any one of [1] to [3], wherein the imaging unit has an optical splitting unit configured to split the emitted light into first and second split light paths, a first image sensor arranged on the first split light path, and a second image sensor arranged on the second split light path, wherein the optical filter is arranged between the optical splitting unit and the first image sensor on the first split light path, wherein the first image sensor captures the light transmitted or reflected by the optical filter to output the first image data, and wherein the second image sensor captures the light as the emitted light that has arrived without passing through the optical filter to output the second image data." According to this configuration, when the splitting unit splits the light into the first and second split light paths, the acquisition of the first image data and the acquisition of the second image data described above can be performed simultaneously and wavelength information can be acquired efficiently.

An inspection apparatus according to an aspect of the present disclosure may be [5] "the inspection apparatus according to any one of [1] to [4], wherein the analysis unit derives a transmission intensity, which is an intensity of light transmitted through the optical filter, on the basis of the first image data, derives a total intensity of the emitted light on the basis of the second image data, derives a reflection intensity, which is an intensity of light reflected by the optical filter, on the basis of the transmission intensity and the total intensity, and derives wavelength information on the basis of the transmission intensity and the reflection intensity." In the optical filter, because the light is transmitted or reflected according to the wavelength, the wavelength information can be derived with high accuracy from information about the transmission intensity (an amount of transmitted light) and the reflection intensity (an amount of reflected light).

An inspection apparatus according to an aspect of the present disclosure may be [6] "the inspection apparatus according to any one of [1] to [5], wherein the analysis unit derives a reflection intensity, which is an intensity of light reflected by the optical filter, on the basis of the first image data, derives a total intensity of the emitted light on the basis of the second image data, derives a transmission intensity, which is an intensity of light transmitted through the optical filter, on the basis of the reflection intensity and the total intensity, and derives wavelength information on the basis of the transmission intensity and the reflection intensity." In the optical filter, because the light is transmitted or reflected according to the wavelength, the wavelength information can be derived with high accuracy from information about the transmission intensity (an amount of transmitted light) and the reflection intensity (an amount of reflected light).

An inspection apparatus according to an aspect of the present disclosure may be [7] "the inspection apparatus according to [6], wherein the analysis unit derives a difference value between the transmission intensity and the reflection intensity and derives wavelength information on the basis of the difference value." The wavelength information can be derived with high accuracy by deriving the wavelength information from the difference value between the transmission intensity and the reflection intensity.

An inspection apparatus according to an aspect of the present disclosure may be [8] "the inspection apparatus according to any one of [1] to [7], wherein the wavelength information is information indicating a centroid wavelength of the emitted light." Thereby, the wavelength information can be appropriately derived.

An inspection apparatus according to an aspect of the present disclosure may be [9] "the inspection apparatus according to any one of [1] to [8], wherein the emitted light is light having a wavelength in an infrared wavelength range." Thereby, the emitted infrared light generated by the semiconductor apparatus can be captured.

An inspection apparatus according to an aspect of the present disclosure is [10] "an inspection apparatus for inspecting a semiconductor apparatus, the inspection apparatus comprising: a stage configured to hold the semiconductor apparatus; an optical filter having a transmission characteristic in which transmittance varies linearly in a predetermined wavelength range and configured to transmit or reflect emitted light generated from the semiconductor apparatus on the basis of the transmission characteristic; a first image sensor configured to capture the light transmitted through the optical filter to output first image data; a second image sensor configured to image light reflected by the optical filter to output second image data; and an analysis unit configured to derive wavelength information about the emitted light on the basis of the first image data and the second image data."

In the inspection apparatus according to the aspect of the present disclosure, the emitted light generated from the semiconductor apparatus is transmitted and reflected by the optical filter in accordance with the wavelength. Also, the wavelength information about the emitted light is derived on the basis of the first image data obtained by capturing the transmitted light and the second image data obtained by capturing the reflected light. Thus, in the inspection apparatus according to the aspect of the present disclosure, because the optical filter is used to transmit and reflect the emitted light in accordance with the wavelength, the first and second image data are image data according to the wavelength of the light. By deriving light wavelength information from such image data, it is possible to acquire light wavelength information with high accuracy. Furthermore, in this method for acquiring the wavelength information, because the wavelength information about the emitted light can be acquired spatially all at once and a process for changing a band filter or the like is unnecessary, the wavelength information can be easily acquired. As described above, the inspection apparatus according to the aspect of the present disclosure can acquire wavelength information about emitted light generated from a semiconductor apparatus with high accuracy and easily.

An inspection method according to an aspect of the present disclosure is [11] "an inspection method for inspecting a semiconductor apparatus, the inspection method comprising: transmitting or reflecting emitted light generated from the semiconductor apparatus by an optical filter having a transmission characteristic in which transmittance varies linearly in a predetermined wavelength range, on the basis of the transmission characteristic; capturing light transmitted or reflected by the optical filter to output first image data; capturing light as emitted light that has arrived without passing through the optical filter to output second image data; and deriving wavelength information about the emitted light on the basis of the first image data and the second image data."

An inspection method according to an aspect of the present disclosure is [12] "an inspection method for inspecting a semiconductor apparatus, the inspection method comprising: transmitting or reflecting emitted light generated from the semiconductor apparatus by an optical filter having a transmission characteristic in which transmittance varies linearly in a predetermined wavelength range, on the basis of the transmission characteristic; capturing light transmitted through the optical filter to output first image data; capturing light reflected by the optical filter to output second image data; and deriving wavelength information about the emitted light on the basis of the first image data and the second image data."

**Advantageous Effects of Invention**

According to the inspection apparatus and the inspection method according to the aspects of the present disclosure, wavelength information about emitted light generated from a semiconductor apparatus can be acquired with high accuracy and easily.

**Brief Description of Drawings**

FIG. 1 is a side view schematically showing an inspection apparatus according to a first embodiment of the present disclosure.
FIG. 2 is an explanatory diagram of an optical spectrum and characteristics of an LRG filter.
FIG. 3 is a side view showing a state in which a tilt filter is withdrawn from a light path by a switching unit.
FIG. 4(a) is a diagram showing a transmission image.
FIG. 4(b) is a diagram showing a total light amount image.
FIG. 5 is a diagram showing a display example of wavelength information.
FIG. 6 is a diagram showing a display example of wavelength information.
FIG. 7 is a flowchart of an inspection method.
FIGS. 8(a) and 8(b) are explanatory diagrams of an imaging mechanism according to a first modification example of the first embodiment.
FIGS. 9(a) and 9(b) are explanatory diagrams of an imaging mechanism according to a second modification example of the first embodiment.

FIGS. 10(a) and 10(b) are explanatory diagrams of an imaging mechanism according to a third modification example of the first embodiment.

FIG. 11 is a side view schematically showing an inspection apparatus according to a second embodiment of the present disclosure.

FIGS. 12(a) to 12(d) are explanatory diagrams of an imaging unit according to a modification example of the second embodiment.

FIG. 13 is an explanatory diagram of an imaging unit according to a modification example.

**Description of Embodiments**

Hereinafter, embodiments will be described in detail with reference to the drawings. The same or corresponding parts are denoted by the same reference signs in the drawings and redundant descriptions will be omitted.

[First embodiment]

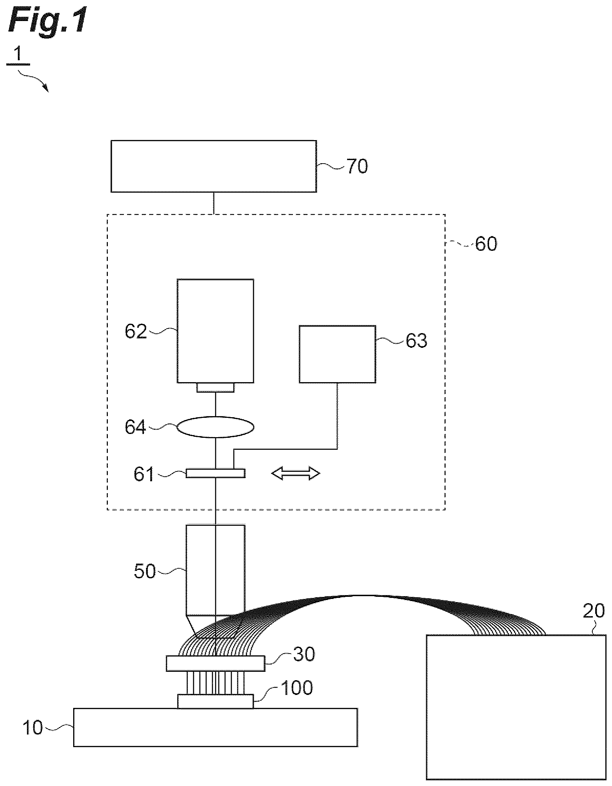

FIG. 1 is a side view schematically showing an inspection apparatus 1 according to a first embodiment. The inspection apparatus 1 is a apparatus for inspecting a semiconductor apparatus 100. The semiconductor apparatus 100 may be a logic apparatus, which is an integrated circuit (IC) having a PN junction such as a transistor or a large-scale integration circuit (LSI), a memory apparatus, an analog apparatus, a mixed-signal apparatus, which is a combination thereof, or a power semiconductor apparatus (a power apparatus) such as a high-current/high-voltage MOS transistor, a bipolar transistor, or an IGBT.

For example, in the case of a semiconductor apparatus made of a semiconductor material that transmits infrared light, such as silicon, the semiconductor apparatus 100 can generate emitted light (emitted infrared light) having a wavelength in the infrared wavelength range (e.g., in a wavelength band between 780 nm and 1 mm) and emit infrared light to the outside of the semiconductor apparatus 100. Moreover, the semiconductor apparatus 100 may be a semiconductor apparatus made of a semiconductor material that transmits visible light, such as SiC or GaN. A semiconductor apparatus made of such a material can generate emitted light (emitted visible light) having a wavelength in the visible wavelength (e.g., in the wavelength band greater than or equal to 300 nm and less than 780 nm) in the semiconductor apparatus 100 and emit emitted visible light to the outside of semiconductor apparatus 100. These types of emitted light may be caused due to a failure of the semiconductor apparatus 100. The following description assumes that the semiconductor apparatus 100 is a semiconductor apparatus that primarily generates emitted infrared light. However, as described above, the semiconductor apparatus 100 may also be a semiconductor apparatus that generates emitted light including a visible wavelength.

The inspection apparatus 1 transmits or reflects the emitted light (emitted infrared light) generated from the semiconductor apparatus 100 in accordance with a wavelength component, and captures the transmitted or reflected light to acquire an image (first image data). Moreover, the inspection apparatus 1 acquires an image (second image data) by capturing the light output from the semiconductor apparatus 100. Also, the inspection apparatus 1 derives wavelength information about the light output from the semiconductor apparatus 100 on the basis of the above-described two images (details will be described below).

As shown in FIG. 1, the inspection apparatus 1 includes a stage 10, a semiconductor tester 20, a probe card 30, an objective lens 50, an imaging mechanism 60, and a computer 70 (an analysis unit).

The semiconductor apparatus 100 is placed and held on the stage 10. The stage 10 may be an XY stage configured to be movable in the XY direction (a forward/backward or left/right direction).

The semiconductor tester 20 is a control unit for driving the semiconductor apparatus 100 (e.g., LSI), which is an object to be inspected. The semiconductor tester 20 applies a voltage or an electric current to the semiconductor apparatus 100. The semiconductor tester 20 drives the semiconductor apparatus 100 by providing a predetermined drive clock or drive pattern. the semiconductor tester 20 is electrically connected to the semiconductor apparatus 100 via the probe card 30.

The objective lens 50 is arranged opposite the semiconductor apparatus 100, which is the object to be inspected, and condenses the infrared light generated from a predetermined field of view and guides the infrared light to the infrared camera 62. In addition, the objective lens 50 may be a solid immersion lens.

The imaging mechanism 60 is configured to include an LRG (Liner Reflectance Gradient on the wavelength axis) filter 61 (an optical filter), an infrared camera (a camera) 62 (an image sensor or an imaging unit), a switching unit 63, and an image forming lens 64.

The LRG filter 61 is a filter created using a special optical material and separates the emitted infrared light (emitted light) generated from the semiconductor apparatus 100 by transmitting or reflecting the light in accordance with its wavelength. The LRG filter 61 has a transmission characteristic in which transmittance varies linearly in a predetermined wavelength range, and transmits or reflects emitted infrared light on the basis of the above-described transmission characteristic. The LRG filter 61 is generally arranged perpendicular to the light path. The LRG filter 61 may separate the emitted visible light (emitted light) generated from the semiconductor apparatus 100 by transmitting or reflecting the light in accordance with its wavelength. In this case, the LRG filter 61 has a transmission characteristic in which the transmittance varies linearly in a predetermined wavelength range, and transmits or reflects emitted visible light (emitted light) on the basis of the above-described transmission characteristic. In this case, in the LRG filter 61, the light transmittance (and reflectance) changes gradually in accordance with changes in wavelength in a predetermined visible wavelength range (a wavelength band of wavelengths $\lambda_1$ to $\lambda_2$), and the light transmittance (and reflectance) is constant in wavelength bands other than the predetermined wavelength range (i.e., the wavelength side lower than the wavelength $\lambda_1$ and the wavelength side higher than the wavelength $\lambda_2$) regardless of changes in wavelength.

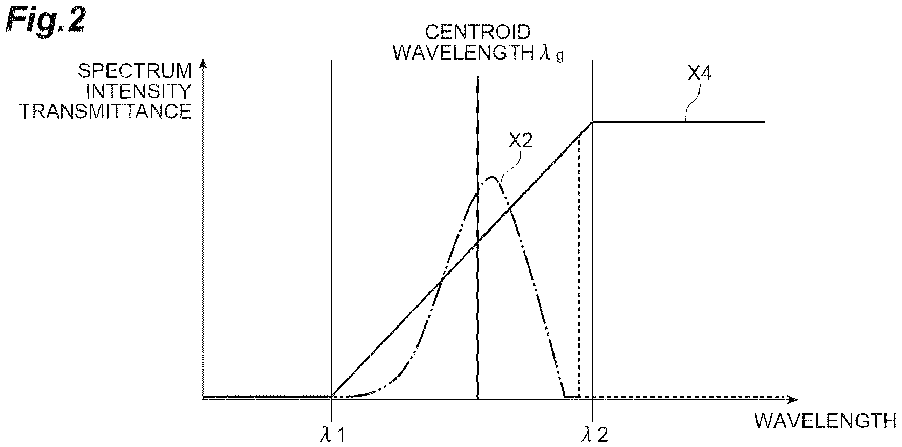

FIG. 2 is an explanatory diagram of the spectrum of light and the characteristics of the LRG filter 61. In FIG. 2, the horizontal axis represents a wavelength and the vertical axis represents a spectral intensity (for the spectrum of light) and transmittance (for the LRG filter 61). As shown in a characteristic X4 of the LRG filter 61 of FIG. 2, in the LRG filter 61, the light transmittance (and reflectance) changes gradually as the wavelength changes in the predetermined wavelength range (a wavelength range of the wavelengths $\lambda_1$ to $\lambda_2$) and the light transmittance (and reflectance) is constant regardless of a change in wavelength in wavelength ranges other than the predetermined wavelength range (i.e., a lower wavelength side of the wavelength $\lambda_1$ and a higher wavelength side of the wavelength $\lambda_2$). In other words, in a predetermined wavelength range (the wavelength band of the wavelengths $\lambda_1$ to $\lambda_2$), the light transmittance changes to monotonically increase (the reflectance changes to monotonically decrease) as the wavelength changes. Because transmittance and reflectance are negatively correlated, i.e., as one changes in the direction of increasing, the other changes in the direction of decreasing, they may hereinafter be referred to simply as "transmittance" instead of "transmittance (and reflectance)". The term "constant light transmittance regardless of change in wavelength" includes, for example, a case where the change in transmittance for a change in wavelength of 1 nm is 0.1% or less as well as a case where the transmittance is completely constant. On the lower wavelength side of the wavelength $\lambda_1$, the light transmittance is approximately 0% regardless of a change in the wavelength. On the higher wavelength side of the wavelength $\lambda_2$, the light transmittance is approximately 100% regardless of a change in the wavelength. In addition, the term "light transmittance is approximately 0%" includes a transmittance of approximately (0%+10%) and the term "light transmittance is approximately 100%" includes a transmittance of approximately (100%-10%). As described above, the LRG filter 61 is a separate optical element with a wavelength band of a predetermined width (a width of wavelengths $\lambda_1$ to $\lambda_2$) in which the transmittance changes as the wavelength changes. In addition, if light enters the LRG filter 61 in a wavelength band other than the predetermined wavelength range (i.e., a lower wavelength side of the wavelength $\lambda_1$ and a higher wavelength side of the wavelength $\lambda_2$), it will cause measurement errors. To prevent this, bandpass filters, short-pass filters, or long-pass filters may be used to shield light in wavelength bands other than the specified wavelength range. Moreover, the LRG filter 61 may be designed so that the wavelengths $\lambda_1$ and $\lambda_2$ of the LRG filter 61 are set outside the sensitivity range of the image sensor used in the camera 62. Moreover, if there is an error in the cut wavelength of the wavelength filter, it is desirable for the light transmittance (and the light reflectance) to be constant regardless of the change in the wavelength to minimize the effect of the error.

Returning to FIG. 1, the infrared camera (camera) 62 captures the light transmitted through the LRG filter 61 and outputs a transmission image (first image data). Moreover, the infrared camera 62 captures emitted infrared light that has arrived without passing through the LRG filter 61 to output a total light amount image (second image data). Thus, the infrared camera 62 may perform first imaging for capturing light that has passed through the LRG filter 61, or second imaging for capturing light that has arrived without passing through the LRG filter 61. The switching unit 63 to be described below switches the imaging between the first imaging and the second imaging by changing the position of the LRG filter 61. It is only necessary for the infrared camera 62 to be a camera equipped with a sensor sensitive to the infrared wavelength range of near- and mid-infrared light. For example, the infrared camera 62 may be an MCT (Mercury Cadmium Telluride/HgCdTe) sensor, an InGaAs sensor, or an InSb sensor. In addition, when the semiconductor apparatus 100 is a semiconductor apparatus that generates emitted visible light, the camera 62 may be a camera with a sensor that is sensitive to visible light wavelengths. For example, it may be a silicon image sensor, a surface-incident InGaAs sensor, or the like.

The image forming lens 64 is a lens that forms an image of the emitted infrared light condensed by the objective lens 50. In addition, the arrangement position of the LRG filter 61 described above may be on the downstream side of the image forming lens 64 (the infrared camera 62 side) or the upstream side of the image forming lens 64 (the objective lens 50 side). However, if the LRG filter 61 is placed on the downstream side of the image forming lens 64 (on the infrared camera 62 side), the image forming lens 64 needs to be corrected because it causes aberrations. Moreover, if NA is high, there is a possibility that the centroid wavelength will deviate in a visual field. However, in this case, it is only necessary for the image forming lens 64 to form a telecentric optical system.

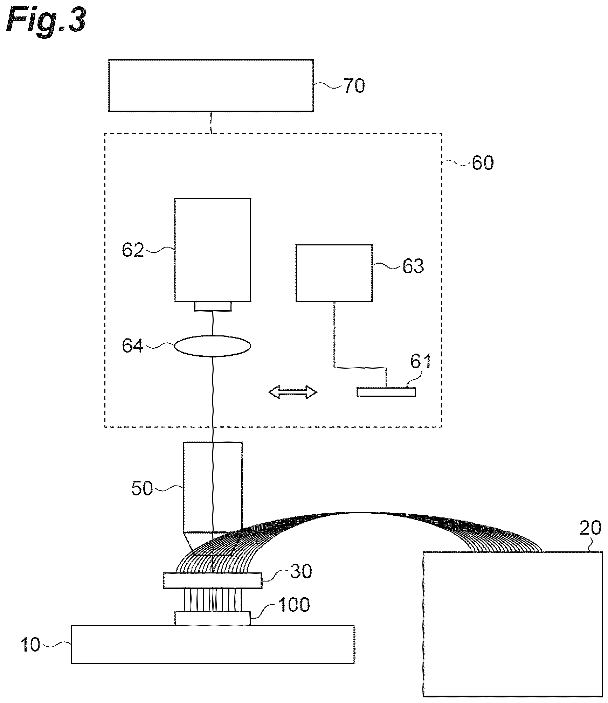

The switching unit 63 is configured to switch the state between a state in which the LRG filter 61 is provided on the light path between the objective lens 50 and the infrared camera 62 (a state in which the above-described first imaging is performed (see FIG. 1)) and a state in which the LRG filter 61 is not provided (a state in which the above-described second imaging is performed (see FIG. 3)). The switching unit 63 implements the above-described switching operation by moving the LRG filter 61 (changing the position of the LRG filter 61). In other words, when the above-described first imaging is performed, the switching unit 63 moves the LRG filter 61 so that the LRG filter 61 is positioned on the light path between the objective lens 50 and the infrared camera 62 and light transmitted through the LRG filter 61 is captured by the infrared camera 62. Moreover, in the case of the above-described second imaging, as shown in FIG. 3, the switching unit 63 moves the LRG filter 61 so that the LRG filter 61 is not positioned on the light path between the objective lens 50 and the infrared camera 62 and the emitted infrared light that has arrived without passing through the LRG filter 61 is captured by the infrared camera 62. The switching unit 63 may be, for example, a filter wheel or filter slide.

The computer 70 is physically configured to include a memory such as a RAM or a ROM, a processor (an arithmetic circuit) such as a CPU, a communication interface, and a storage unit such as a hard disk. The computer 70 operates when the CPU of a computer system executes a program stored in the memory. The computer 70 may be configured to include a microcomputer or an FPGA.

The computer 70 derives wavelength information about emitted infrared light generated from the semiconductor apparatus 100 on the basis of the transmission image and total light amount image described above. The computer 70 derives a transmission intensity (an amount of transmitted light), which is the intensity of light transmitted through the LRG filter 61 on the basis of the transmission image, and derives a total intensity of emitted infrared light on the basis of the total light amount image. Also, the computer 70 derives the reflection intensity (amount of reflected light), which is the intensity of light reflected by the LRG filter 61 specifically by subtracting the transmission intensity from the total intensity on the basis of the transmission intensity and the total intensity. For example, when the transmission intensity is denoted by T, the reflection intensity is denoted by R, the total light amount is denoted by A, and the difference value between the transmission intensity T and the reflection intensity R is denoted by D, R=A-T and D=2T-A are valid. The computer 70 derives wavelength information on the basis of an amount of transmitted light and an amount of reflected light. The computer 70 derives a difference value between the amount of transmitted light and the amount of reflected light and derives the wavelength information on the basis of the difference value. The wavelength information here is information indicating the centroid wavelength of the light output from the semiconductor apparatus 100. Moreover, the transmission intensity (an amount of transmitted light) may be an integrated value of intensities in areas of the image corresponding to the emitted infrared light in the transmission image. Moreover, a total intensity (a total amount of light) may be an integrated value of intensities in areas of the image corresponding to the emitted infrared light in the total light amount image. In this case, the reflection intensity (the amount of reflected light) derived by a calculation process is obtained as an integrated value of intensities in areas of the image corresponding to the emitted infrared light. Furthermore, the transmission intensity (the amount of transmitted light) may be the intensity of each pixel constituting the area of the image corresponding to the emitted infrared light in the transmission image. Moreover, the total intensity (a total amount of light) may be the intensity of each pixel constituting the area of the image corresponding to the emitted infrared light in the total light amount image. In this case, the reflection intensity (reflected light intensity) derived by a calculation process is obtained as the intensity of each pixel constituting the area of the image corresponding to the emitted infrared light. Hereinafter, an example of a principle of centroid wavelength calculation will be described in detail with reference to FIG. 2.

As described above, the LRG filter 61 reflects all light on the lower wavelength side of the wavelength $\lambda_1$ and transmits all light on the higher wavelength side of the wavelength $\lambda_2$, and the transmittance of light changes linearly in accordance with the wavelength in the wavelength band of the wavelengths $\lambda_1$ to $\lambda_2$. In this case, the transmittance $h(\lambda)$ in a relationship between the wavelengths $\lambda_1$ and $\lambda_2$ is expressed by the following Eq. (1), and the reflectance $1-h(\lambda)$ is expressed by the following Eq. (2).

$$h(\lambda)=(\lambda-\lambda_1)/(\lambda_2-\lambda_1) \ (1)$$

$$1-h(\lambda)=(\lambda_2-\lambda)/(\lambda_2-\lambda_1) \ (2)$$

Moreover, it is clear that the wavelength $\lambda 50\%$ at which the reflectance is 50% is expressed by the following Eq. (3).

$$\lambda 50\%=(\lambda_2+\lambda_1)/2 \ (3)$$

When a certain spectrum $f(\lambda)$ is indicated by a waveform X2 in FIG. 2 and located between $\lambda_1$ and $\lambda_2$ and is negligible at wavelengths shorter than $\lambda_1$ and longer than $\lambda_2$, the following Eq. (4) is valid under the assumption that an amount of reflected light and an amount of transmitted light are equal.

$$\int f(\lambda)h(\lambda)d\lambda = \int f(\lambda)(1-h(\lambda))d\lambda \ (4)$$

When Eq. (4) is modified, the following Eq. (5) is obtained.

$$2\int f(\lambda)h(\lambda)d\lambda = \int f(\lambda)d\lambda \ (5)$$

If Eq. (1) is substituted into Eq. (5), $2\int f(\lambda)(\lambda-\lambda_1)/(\lambda_2-\lambda_1)d\lambda = \int f(\lambda)d\lambda$ is set, both sides are further divided by $2\int f(\lambda)d\lambda/(\lambda_2-\lambda_1)$, the following Eq. (6) is obtained.

$$\int f(\lambda)(\lambda-\lambda_1)d\lambda / \int f(\lambda)d\lambda = (\lambda_2-\lambda_1)/2$$
$$\int f(\lambda)\lambda d\lambda / \int f(\lambda)d\lambda = (\lambda_2+\lambda_1)/2 \ (6)$$

Considering Eq. (3), it is clear that the right side of Eq. (6) is $\lambda 50\%$ and the left side is the centroid of $f(\lambda)$, which is generally any function. The left side of Eq. (6) is set as $\lambda_f$. Based on the above, for any spectrum through the LRG filter 61 whose transmittance varies linearly with a wavelength, when the amount of transmitted light is equal to the amount of reflected light, the centroid of the spectrum, $\lambda_f$, is $\lambda 50\%$.

Subsequently, the second spectrum $g(\lambda)$ is considered. For spectrum $g(\lambda)$, the spectrum is also contained entirely between $\lambda_1$ and $\lambda_2$. Now, for the spectra $f(\lambda)$ and $g(\lambda)$, a normalized difference value between transmitted light and reflected light is calculated. $T_f$ denotes the transmitted light of $f(\lambda)$, $R_f$ denotes the reflected light, $A_f$ denotes the total light amount, and $D_f$ denotes a difference value between transmitted light and reflected light. $T_g$ denotes the transmitted light of $g(\lambda)$, $R_g$ denotes the reflected light, $A_g$ denotes the total light amount, and $D_g$ denotes a difference value between transmitted light and reflected light. Moreover, $\lambda_g$ denotes the centroid of $g(\lambda)$. In this case, $T_f$, $R_f$, $T_g$, and $R_g$ are measured values and $A_f$, $A_g$, $D_f$, and $D_g$ are values that can be calculated directly from the measured values. Each of these values is also expressed by the following equation.

$$T_f = \int f(\lambda)h(\lambda)d\lambda = \int f(\lambda)(\lambda-\lambda_1)/(\lambda_2-\lambda_1)d\lambda \ (7)$$

$$T_g = \int g(\lambda)h(\lambda)d\lambda = \int g(\lambda)(\lambda-\lambda_1)/(\lambda_2-\lambda_1)d\lambda \ (8)$$

$$R_f = \int f(\lambda)(1-h(\lambda))d\lambda = \int f(\lambda)(\lambda_2-\lambda)/(\lambda_2-\lambda_1)d\lambda \ (9)$$

$$R_g = \int g(\lambda)(1-h(\lambda))d\lambda = \int g(\lambda)(\lambda_2-\lambda)/(\lambda_2-\lambda_1)d\lambda \ (10)$$

$$A_f = \int f(\lambda)d\lambda \ (11)$$

$$A_g = \int g(\lambda)d\lambda \ (12)$$

$$D_f = T_f - R_f = 2/(\lambda_2-\lambda_1)*\int \lambda_f(\lambda)d\lambda - (\lambda_2+\lambda_1)/(\lambda_2-\lambda_1)*\int f(\lambda)d\lambda \ (13)$$

$$D_g = T_g - R_g = 2/(\lambda_2-\lambda_1)*\int \lambda_g(\lambda)d\lambda - (\lambda_2+\lambda_1)/(\lambda_2-\lambda_1)*\int g(\lambda)d\lambda \ (14)$$

Here, normalizing the difference value between the transmitted light and the reflected light is equivalent to dividing $D_f$ by $A_f$ and dividing $D_g$ by $A_g$. If the difference between them is denoted by R, the following Eq. (15) is valid.

$$R=D_g/A_g-D_f/A_f$$

$$=\{\int g(\lambda)\lambda d\lambda/\int g(\lambda)d\lambda-\int f(\lambda)\lambda d\lambda/\int f(\lambda)d\lambda\}*2/(\lambda_2-\lambda_1)$$

$$=2(\lambda_g-\lambda_f)/(\lambda_2-\lambda_1) \quad (15)$$

If the difference between the centroid wavelength $\lambda_f$ of the spectrum $f(\lambda)$ and the centroid wavelength $\lambda_g$ of the spectrum $g(\lambda)$ is $\delta\lambda$, the following Eqs. (16) and (17) are valid.

$$R=2\delta\lambda/(\lambda_2-\lambda_1) \quad (16)$$

$$\delta\lambda=R(\lambda_2-\lambda_1)/2 \quad (17)$$

As shown above, the difference between the centroids of two arbitrary spectra $f(\lambda)$ and $g(\lambda)$ can be obtained from calculations that take into account the amount of transmitted light and the amount of reflected light.

Also, when the centroid of $f(\lambda)$ is denoted by $\lambda 50\%$, $D_f$ is 0 because the amount of reflected light and the amount of transmitted light are equal. In other words, the centroid wavelength $\lambda_g$ of any spectrum $g(\lambda)$ is expressed by the following Eq. (18).

$$\lambda_g=\delta\lambda+\lambda 50\% \quad (18)$$

As described above, the centroid wavelength of the spectrum (i.e., the wavelength information about the light) can be calculated from a design value of the LRG filter 61, the amount of transmitted light, and the amount of reflected light. Also, the inspection apparatus 1 inspects the semiconductor apparatus 100 using the centroid wavelength (wavelength information) as described above.

Moreover, the centroid wavelength $\lambda_g$ of any spectrum $g(\lambda)$ can be obtained by the following Eqs. (19) and (20). In this case, the transmitted light $T_g$, the reflected light $R_g$, the total amount of light $A_g$, and the centroid $\lambda_g$ of $g(\lambda)$ are defined by Eqs. (21), (22), (23), and (24), respectively. Eq. (21) is synonymous with the above Eq. (8), Eq. (22) is synonymous with the above Eq. (10), Eq. (23) is synonymous with the above Eq. (12), and Eq. (24) is synonymous with the above Eq. (18).

[Math. 1]

$$\frac{T_g - R_g}{T_g + R_g} = \frac{T_g - R_g}{A_g} = \frac{2T_g - A_g}{A_g} = \frac{A_g - 2R_g}{A_g}$$

$$= \frac{\int_{\lambda_1}^{\lambda_2} \frac{2\lambda - (\lambda_1 + \lambda_2)}{\lambda_2 - \lambda_1} g(\lambda) d\lambda}{A_g}$$

$$= \frac{\int_{\lambda_1}^{\lambda_2} \frac{2(\lambda - \lambda_{50\%})}{\lambda_2 - \lambda_1} g(\lambda) d\lambda}{A_g}$$

$$= \frac{\frac{2}{\lambda_2 - \lambda_1} \left\{ \int_{\lambda_1}^{\lambda_2} \lambda g(\lambda) d\lambda - \lambda_{50\%} \int_{\lambda_1}^{\lambda_2} g(\lambda) d\lambda \right\}}{A_g}$$

$$= \frac{2}{\lambda_2 - \lambda_1} (\lambda_g - \lambda_{50\%}) \qquad (19)$$

$$\lambda_g = \frac{\lambda_2 - \lambda_1}{2} \left( \frac{T_g - R_g}{T_g + R_g} \right) + \lambda_{50\%} \qquad (20)$$

$$T_g = \int_{\lambda_1}^{\lambda_2} \frac{\lambda - \lambda_1}{\lambda_2 - \lambda_1} g(\lambda) d\lambda \quad (21)$$

$$R_g = \int_{\lambda_1}^{\lambda_2} \frac{\lambda_2 - \lambda}{\lambda_2 - \lambda_1} g(\lambda) d\lambda \quad (22)$$

$$A_g = T_g + R_g = \int_{\lambda_1}^{\lambda_2} g(\lambda) d\lambda \quad (23)$$

$$\lambda_g = \frac{\int_{\lambda_1}^{\lambda_2} \lambda g(\lambda) d\lambda}{\int_{\lambda_1}^{\lambda_2} g(\lambda) d\lambda} = \frac{\int_{\lambda_1}^{\lambda_2} \lambda g(\lambda) d\lambda}{A_g} \quad (24)$$

Next, an inspection method to be performed using the inspection apparatus 1 will be described with reference to FIGS. 1 to 6.

First, the LRG filter 61 is moved by the switching unit 63 so that the LRG filter 61 is positioned on the light path between the objective lens 50 and the infrared camera 62 (see FIG. 1). Also, the semiconductor apparatus 100 is controlled by the semiconductor tester 20 so that it is not driven. In this state, a dark image (a first dark image) is acquired by the infrared camera 62, and the first dark image is output to the computer 70.

Subsequently, the LRG filter 61 is moved by the switching unit 63 so that the LRG filter 61 is withdrawn from the light path between the objective lens 50 and the infrared camera 62 (see FIG. 3). Also, the semiconductor apparatus 100 is controlled by the semiconductor tester 20 so that it is not driven. In this state, a dark image (a second dark image) is acquired by the infrared camera 62, and the second dark image is output to the computer 70.

Subsequently, the semiconductor apparatus 100 is driven by the semiconductor tester 20, and the semiconductor apparatus 100 is placed in a state in which emitted infrared light can be generated from the semiconductor apparatus 100. Also, the LRG filter 61 is moved by the switching unit 63 so that the LRG filter 61 is positioned on the light path between the objective lens 50 and the infrared camera 62 (see FIG. 1), and the light transmitted through the LRG filter 61 is captured by the infrared camera 62. The captured transmission image is output to the computer 70.

Subsequently, while the semiconductor apparatus 100 continues to be driven by the semiconductor tester 20 and emitted infrared light is generated from the semiconductor apparatus 100, the LRG filter 61 is moved by the switching unit 63 so that the LRG filter 61 is withdrawn from the light path between the objective lens 50 and the infrared camera 62 (see FIG. 3), and the light that has arrived without passing through the LRG filter 61 is captured by the infrared camera 62. The captured total light amount image is output to the computer 70.

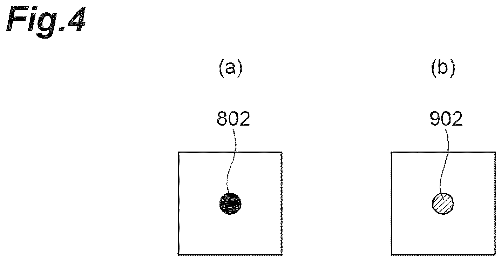

FIG. 4(a) is a diagram showing a transmission image 802 and FIG. 4(b) is a diagram showing a total light amount image 902. Each of the transmission image 802 and the total light amount image 902 is an image corresponding to an amount of light of the captured light. In other words, an integrated value of intensities of a plurality of pixels constituting the image 802 may be used as the transmission intensity (an amount of transmitted light), and an integrated value of intensities of a plurality of pixels constituting the image 902 may be used as a total intensity (a total amount of light).

The computer 70 derives wavelength information (specifically, the centroid wavelength) of the emitted infrared light on the basis of the transmission image and the total light amount image captured by the infrared camera 62. An example of the method for deriving the centroid wavelength has been described above. In addition, the total amount of light may be derived from an image obtained by subtracting the second dark image from the total light amount image. Moreover, the amount of transmitted light may be derived from an image obtained by subtracting the first dark image from the transmission image. Thus, by subtracting the dark image from the measured image, the offset noise caused by camera leakage, apparatus temperature, or the like is canceled, and only the intensity of the emitted infrared light can be acquired.

The imaging conditions for acquiring the transmission image and the total light amount image do not necessarily have to be the same. Even if the exposure times are different, it is acceptable to treat them as being under substantially equivalent conditions by adjusting a digital gain or the like. Furthermore, a plurality of images may be acquired and digitally integrated as necessary. Furthermore, pixels in an area of emitted infrared light may be binned.

The computer 70 displays values of the centroid wavelengths on its display while distinguishing the values using luminance, color (e.g., an LUT display), transmittance, and the like. In this case, the computer 70 may perform transmission or density processing according to the intensity of the emitted infrared light. Moreover, the computer 70 may perform a separate process according to the centroid wavelength (e.g., a process for transmission outside a specific wavelength range or the like) to clearly indicate an abnormal location.

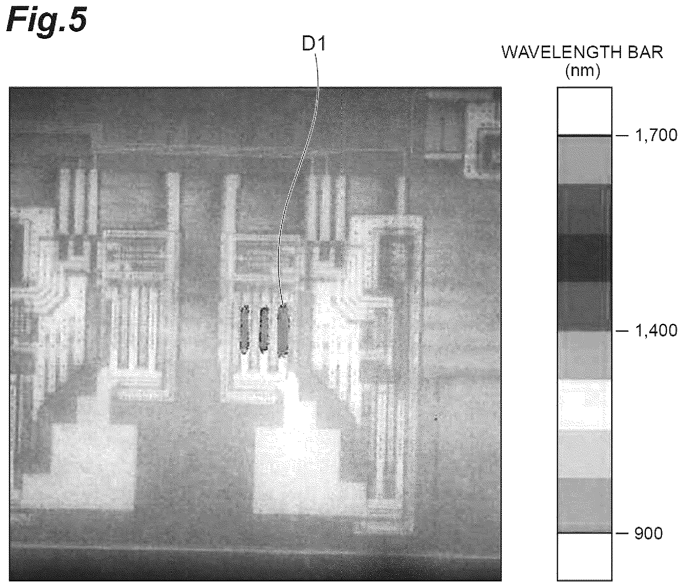

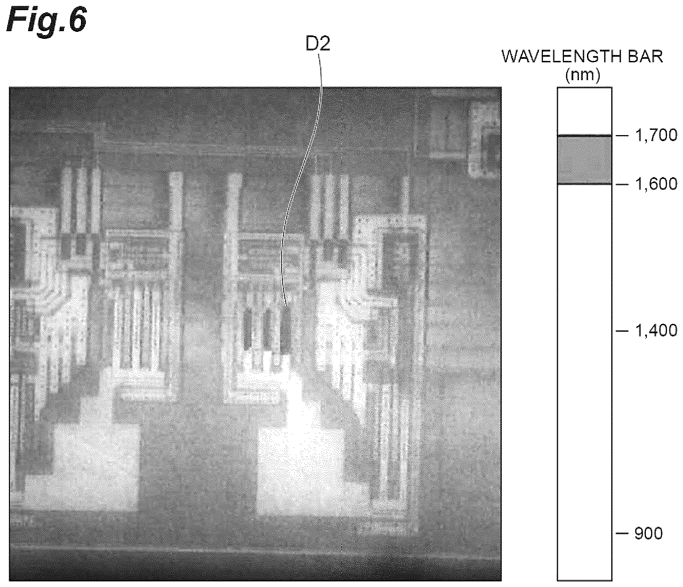

FIGS. 5 and 6 are diagrams showing a display example of the wavelength information (the centroid wavelength). For example, as shown in FIG. 5, a luminance display D1 of the centroid wavelength for each range may be displayed when the LRG filter 61 with a lower-limit wavelength of $\lambda_1$=900 nm and an upper-limit wavelength of $\lambda_2$=1700 nm is used. Moreover, as shown in FIG. 6, for example, a wavelength range can be selected by the wavelength bar (in this case, 1600 nm to 1700 nm is selected), and the luminance display D2 for only this wavelength range can be displayed.

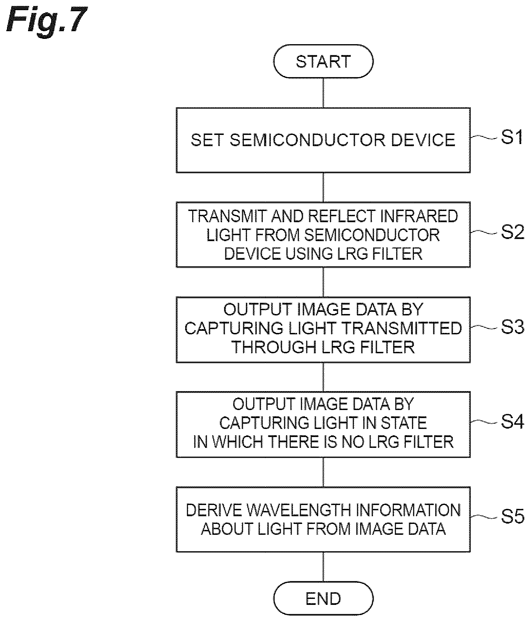

Next, a process for deriving wavelength information within the inspection method to be executed using the inspection apparatus 1 will be described with reference to the flowchart shown in FIG. 7. FIG. 7 is a flowchart of the inspection method (a detailed process for deriving the wavelength information).

In the process for deriving wavelength information as shown in FIG. 7, the semiconductor apparatus 100 is first set on the stage 10 (step S1).

Subsequently, the LRG filter 61 arranged on a light path between the objective lens 50 and the infrared camera 62 transmits emitted infrared light generated from the semiconductor apparatus 100 (step S2).

Subsequently, the light transmitted through the LRG filter 61 is captured by the infrared camera 62 and a transmission image is output to the computer 70 (step S3).

Subsequently, the LRG filter 61 is withdrawn from the light path between the objective lens 50 and the infrared camera 62, and the light that has arrived without passing through the LRG filter 61 is captured by the infrared camera 62, and a total light amount image is output to the computer 70 (step S4).

Also, the wavelength information about the infrared emitted light generated from the semiconductor apparatus 100 is derived by the computer 70 on the basis of the transmission image and the total light amount image (step S5).

Next, functions and effects of the inspection apparatus 1 according to the present embodiment will be described.

The inspection apparatus 1 according to the present embodiment is an inspection apparatus for inspecting the semiconductor apparatus 100 includes the stage 10 configured to hold the semiconductor apparatus 100, the LRG filter 61 having a transmission characteristic in which transmittance varies linearly in a predetermined wavelength range and configured to transmit or reflect emitted infrared light generated from the semiconductor apparatus 100 on the basis of the transmission characteristic, the infrared camera 62 configured to capture the light transmitted through the LRG filter 61 to output a transmission image and capture light, which is the infrared light, arriving without passing through the LRG filter 61 to output a total light amount image, and the computer 70 configured to derive wavelength information about the emitted infrared light on the basis of the transmission image and the total light amount image.

In the inspection apparatus 1, emitted infrared light generated from the semiconductor apparatus 100 is transmitted or reflected by the LRG filter 61 in accordance with the wavelength. Also, the wavelength information about the emitted infrared light is derived on the basis of the transmission image obtained by capturing the light transmitted through the LRG filter 61 and the total light amount image obtained by capturing the emitted infrared light that has arrived without passing through the LRG filter 61. Thus, in the inspection apparatus 1, because the LRG filter 61 is used to transmit or reflect light according to the wavelength, the transmission image is image data according to the wavelength of the light. Moreover, because the transmission image is image data obtained by capturing light transmitted through the LRG filter 61 and the total light amount image is image data obtained by capturing light that has arrived without passing through the LRG filter 61, it is possible to acquire information about light transmitted through the LRG filter 61 and light reflected on the LRG filter 61 from the image data. Thus, information about the light transmitted or reflected in accordance with the wavelength can be acquired with high accuracy and wavelength information of light can be acquired with high accuracy. Furthermore, in this method for acquiring the wavelength information, wavelength information about emitted infrared light can be acquired spatially all at once, and wavelength information can be easily acquired because a process for changing a band filter or the like is unnecessary. As described above, the inspection apparatus 1 of the present embodiment can easily and accurately acquire wavelength information about emitted infrared light generated from the semiconductor apparatus 100.

The imaging unit may have an image sensor that captures the light transmitted through or reflected on the LRG filter 61 and captures the light as the emitted infrared light that has arrived without passing through the LRG filter 61. This image sensor can appropriately image the desired light.

The above-described inspection apparatus 1 may further include the switching unit 63 configured to switch the state between a state in which the LRG filter 61 is provided on the light path between the semiconductor apparatus 100 and the infrared camera 62 and a state in which the LRG filter 61 is not provided. According to this configuration, it is possible to appropriately acquire both the transmission image and the total light amount image described above while switching between the presence and absence of the LRG filter 61.

The computer 70 may derive the transmission intensity, which is the intensity of light transmitted through the LRG filter 61, on the basis of the transmission image, derive the total intensity of emitted infrared light on the basis of the total light amount image, derive the reflection intensity, which is the intensity of light reflected by the LRG filter 61, on the basis of the transmission intensity and the total intensity, and derive wavelength information on the basis of the transmission intensity and the reflection intensity. Because light is transmitted through or reflected on the LRG filter 61 according to a wavelength, wavelength information can be derived with high accuracy from information about a transmission intensity (an amount of transmitted light) and a reflection intensity (an amount of reflected light).

The computer 70 may derive a difference value between the transmission intensity and the reflection intensity and derive wavelength information on the basis of the difference value. The wavelength information can be derived with high accuracy by deriving wavelength information from the difference value between the transmission intensity and the reflection intensity.

The wavelength information may be information indicating a centroid wavelength of the emitted infrared light. Thereby, the wavelength information can be appropriately derived.

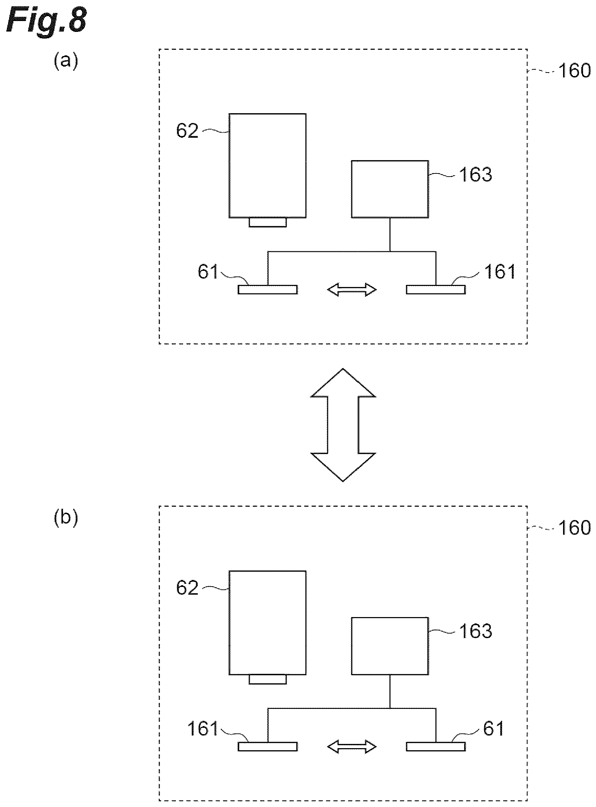

Although the first embodiment has been described above, the configuration of the first embodiment is not limited to the above. Hereinafter, a modification example of the imaging mechanism employed in place of the imaging mechanism 60 will be described with reference to FIGS. 8 to 10.

FIGS. 8(a) and 8(b) are explanatory diagrams of an imaging mechanism 160 according to a first modification example of the first embodiment. The imaging mechanism 160 is different from the above-described imaging mechanism 60 in that a switching unit 163 is configured to switch a filter between an LRG filter 61 and a normalization filter 161.

The imaging mechanism 160 has the LRG filter 61, the normalization filter 161, an infrared camera 62, and the switching unit 163. The normalization filter 161 is a filter that reduces an amount of light uniformly in space, for example, an ND filter. The switching unit 163 is configured to switch the state between a state in which the LRG filter 61 is provided on the light path between the semiconductor apparatus 100 and the infrared camera 62 (see FIG. 8(a)) and a state in which the LRG filter 61 is not provided and the normalization filter 161 is provided (see FIG. 8(b)). The switching unit 163 may implement the above-described switching operation by moving the LRG filter 61 and the normalization filter 161.

In the state in which the normalization filter 161 is provided on the light path, for example, the normalization filter 161 is used to emit about 50% of incident light, and the luminance of the infrared camera 62 is doubled, such that the total amount of light in the state in which the LRG filter 61 is not provided may be derived.

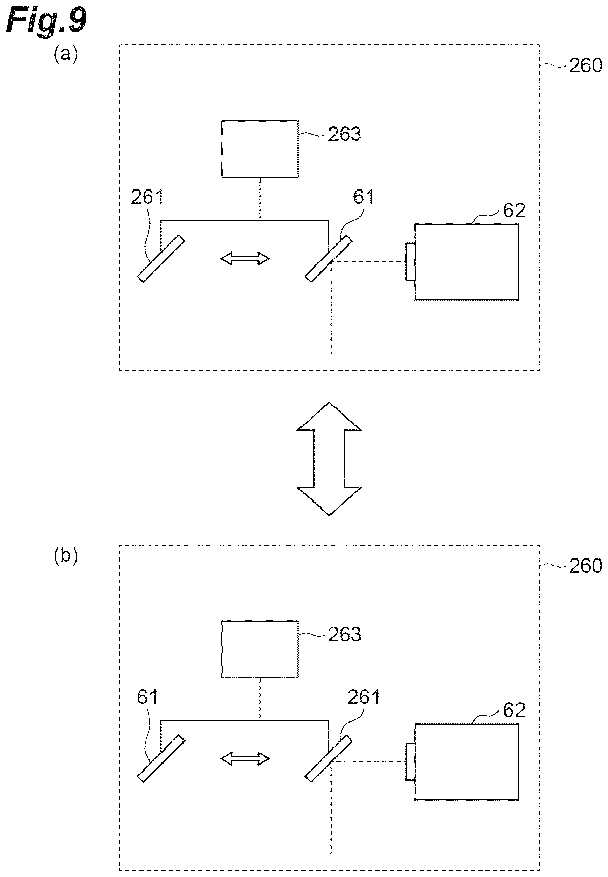

FIGS. 9(a) and 9(b) are explanatory diagrams of an imaging mechanism 260 according to a second modification example of the first embodiment. The imaging mechanism 260 is different from the above-described imaging mechanism 60 in that the infrared camera 62 captures the light reflected on the LRG filter 61.

The imaging mechanism 260 has the LRG filter 61, a mirror 261, the infrared camera 62, and a switching unit 263. The switching unit 263 is configured to switch the state between a state in which the LRG filter 61 is provided on the light path between the semiconductor apparatus 100 and the infrared camera 62 (see FIG. 9(a)) and a state in which the LRG filter 61 is not provided and the mirror 261 is provided (see FIG. 9(b)). The switching unit 163 may implement the above-described switching operation by moving the LRG filter 61 and the mirror 261.

In this case, the infrared camera 62 is provided at a position where the light reflected by the LRG filter 61 is captured in the state in which the LRG filter 61 is provided on the light path (see FIG. 9(a)) and provided at a position where the light reflected by the mirror 261 is captured in a state in which the mirror 261 is provided on the light path (see FIG. 9(b)). In the state in which the mirror 261 is provided on the above-described light path, the total amount of emitted infrared light is acquired.

The computer 70 derives the reflection intensity, which is the intensity of light reflected by the LRG filter 61, from the reflection image (see FIG. 9(a)), derives the total intensity of emitted infrared light from the total light amount image (see FIG. 9(b)), derives the transmission intensity, which is the intensity of light transmitted through the LRG filter 61, on the basis of the reflection intensity and the total intensity, and derives the wavelength information about the infrared light on the basis of the transmission intensity and the reflection intensity.

In detail, the computer 70 executes a process of deriving wavelength information about emitted infrared light on the basis of the reflection image and total light amount image described above. The computer 70 derives the reflection intensity (the amount of reflected light), which is the intensity of the emitted infrared light reflected on the LRG filter 61, on the basis of the reflection image, and derives the total intensity (the total amount of light) of the emitted infrared light on the basis of the total light amount image. Also, the computer 70 derives the transmission intensity (the amount of transmitted light), which is the intensity of the emitted infrared light transmitted through the LRG filter 61, specifically by subtracting the reflection intensity from the total intensity on the basis of the reflection intensity and the total intensity. For example, when the transmission intensity is denoted by T, the reflection intensity is denoted by R, the total amount of light is denoted by A, and a difference value between the transmission intensity T and the reflection intensity R is denoted by D, $T=A-R$ and $D=A-2R$ are valid. Moreover, the reflection intensity (the amount of reflected light) may be an integrated value of the intensities in the areas of the image corresponding to the emitted infrared light in the reflected image. Moreover, the total intensity (the total amount of light) may be an integrated value of the intensities in the areas of the image corresponding to the emitted infrared light in the total light amount image. In this case, the transmission intensity (the amount of transmitted light) derived by a calculation process is obtained as an integrated value of the intensities in the areas of the image corresponding to the emitted infrared light. Furthermore, the reflection intensity (the amount of reflected light) may be an intensity of each pixel constituting the area of the image corresponding to the emitted infrared light in the reflected image. Moreover, the total intensity (the total amount of light) may be an intensity of each pixel constituting the area of the image corresponding to the emitted infrared light in the total light amount image. In this case, the transmission intensity (the amount of transmitted light) derived by a calculation process is obtained as an intensity of each pixel constituting the area of the image corresponding to the emitted infrared light.

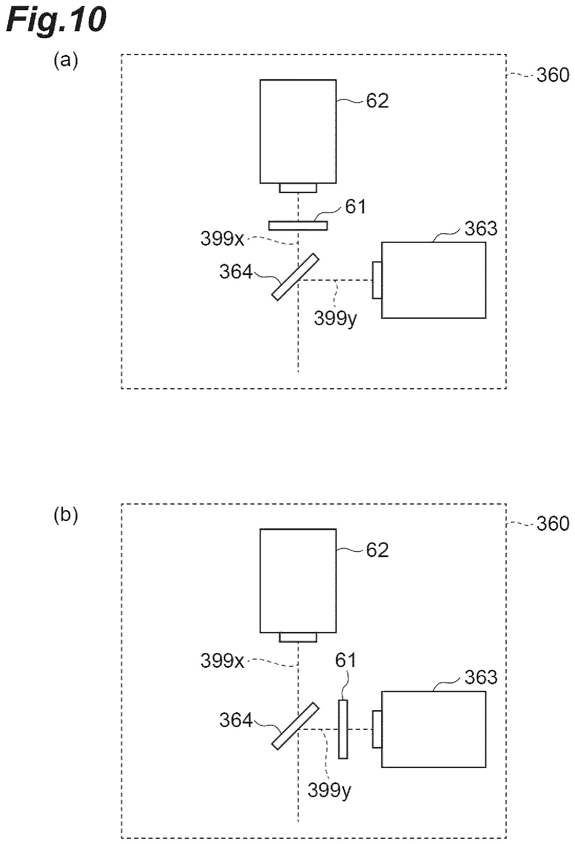

FIG. 10(a) is an explanatory diagram of an imaging mechanism 360 according to a third modification example of the first embodiment. Unlike the above-described imaging mechanism 60, an imaging mechanism 360 has two infrared cameras 62 and 363 and simultaneously acquires a transmission image and a total light amount image.

The imaging mechanism 360 has an LRG filter 61, an infrared camera 62 (a first image sensor), an infrared camera 363 (a second image sensor), and a beam splitter 364 (an optical splitting unit). The beam splitter 364 is a splitter that splits the emitted infrared light output from a semiconductor apparatus 100 into a transmitted light path 399x (a first split light path) and a reflected light path 399y (a second split light path). The beam splitter 364 is, for example, a half-mirror or the like, and splits light by transmitting and reflecting the light. The infrared camera 62 is arranged on the transmitted light path 399x. The infrared camera 363 is arranged on the reflected light path 399y. Moreover, the LRG filter 61 is arranged on the transmitted light path 399x.

According to this configuration, the emitted infrared light is split by the beam splitter 364 into the transmitted light path 399x and the reflected light path 399y, and the acquisition of a transmission image (first image data) from the infrared camera 62 provided on the transmitted light path 399x and the acquisition of a total light amount image (second image data) from the infrared camera 363 provided on the reflected light path 399y can be performed simultaneously. In this case, the wavelength information can be derived efficiently.

In addition, as shown in FIG. 10(b), the LRG filter 61 may be arranged on the reflected light path 399y. In this case, the reflected light path 399y is a first split light path and the transmitted light path 399x is a second split light path.

[Second embodiment]

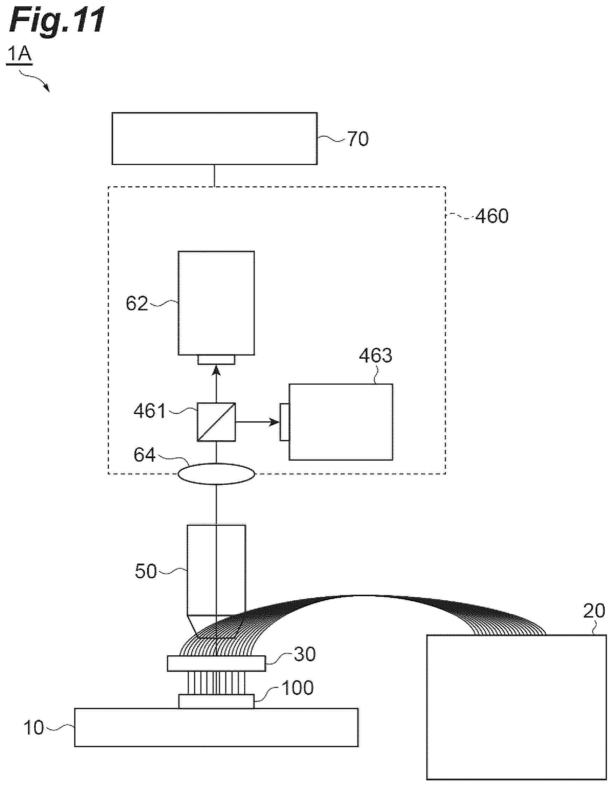

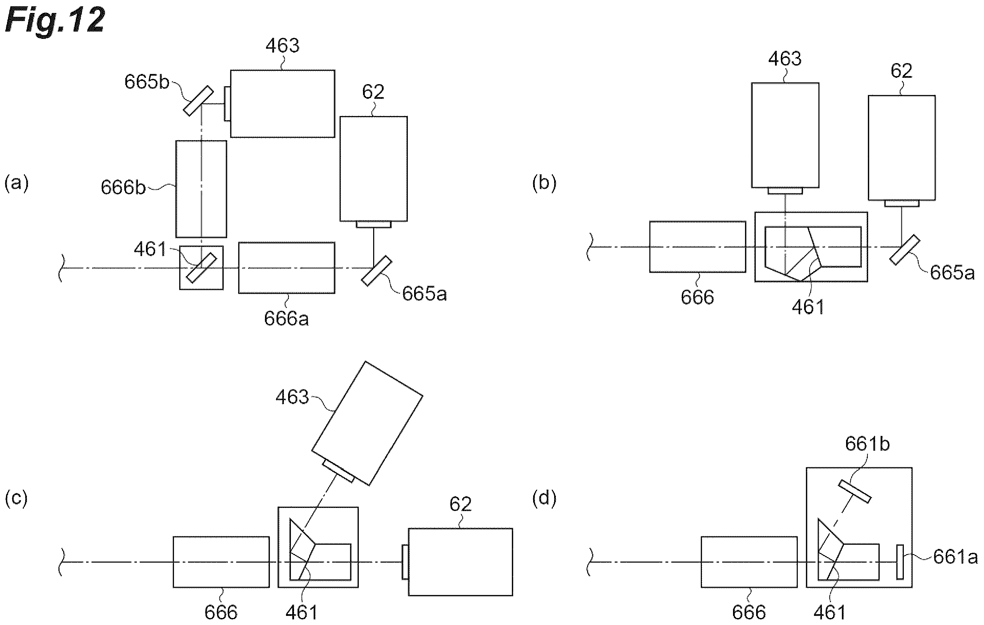

Next, a second embodiment of the present disclosure will be described with reference to FIGS. 11 and 12. In the second embodiment, differences from the first embodiment will be mainly described, and descriptions that are redundant with those of the first embodiment will be omitted.

FIG. 11 is a side view schematically showing an inspection apparatus 1A according to the second embodiment. The inspection apparatus 1A includes an imaging mechanism 460 with infrared cameras 62 and 463, an image forming lens 64, and an LRG dichroic mirror 461. The imaging mechanism 460 has the LRG dichroic mirror 461 as an optical filter. The LRG dichroic mirror 461 has a transmission characteristic in which transmittance varies linearly in a predetermined wavelength range, and transmits and reflects emitted infrared light generated from the semiconductor apparatus 100 on the basis of the transmission characteristic.

Moreover, the imaging mechanism 460 has an infrared camera 62 (a first image sensor) and an infrared camera 463 (a second image sensor) as imaging units. The infrared camera 62 captures the light transmitted through the LRG dichroic mirror 461 and outputs a transmission image (first image data). The infrared camera 463 captures the light reflected by the LRG dichroic mirror 461 and outputs a reflection image (second image data).

The computer 70 derives wavelength information about emitted infrared light on the basis of the transmission and reflection images described above. An example of a wavelength information derivation method is as described above.

In the inspection apparatus 1A for the present embodiment, emitted infrared light generated from the semiconductor apparatus 100 is transmitted and reflected by the LRG dichroic mirror 461 in accordance with a wavelength. Also, wavelength information about the emitted infrared light is derived on the basis of the transmission image obtained by capturing the transmitted light and the reflection image obtained by capturing the reflected light. Thus, in the inspection apparatus 1A, because the LRG dichroic mirror 461 is used to transmit and reflect emitted infrared light in accordance with a wavelength, the transmission and reflection images are image data according to the wavelength of the light. By deriving light wavelength information from such image data, it is possible to acquire light wavelength information with high accuracy. Furthermore, in this method for acquiring wavelength information, wavelength information about emitted infrared light can be acquired spatially all at once, and wavelength information can be easily acquired because a process for changing a band filter or the like is unnecessary. As described above, the inspection apparatus 1A of this embodiment can easily and accurately acquire wavelength information about emitted infrared light generated from the semiconductor apparatus 100.

A configuration of the imaging unit in the second embodiment is not limited to the above-described aspect, but may be as shown in FIGS. 12(a) to 12(d). In the example shown in FIG. 12(a), light transmitted through the LRG dichroic mirror 461 is transmitted through an image forming lens 666a and reflected by a mirror 665a and captured by an infrared camera 62. The light reflected by the LRG dichroic mirror 461 passes through an image forming lens 666b and is reflected by the mirror 665b and captured by the infrared camera 463. In the examples shown in FIGS. 12(b) and 12(c), the LRG dichroic mirror 461 is provided within the prism. In the examples shown in FIGS. 212(b) and 12(c), light transmitted through the LRG dichroic mirror 461 is reflected by the mirror 665a through the prism and captured by the infrared camera 62. The light reflected by the LRG dichroic mirror 461 is reflected by the prism and captured by the infrared camera 463. If the LRG dichroic mirror 461 is provided within the prism, a degree of freedom of the layout of the infrared cameras 62 and 463 is improved. In the example shown in FIG. 12(d), the prism with the built-in LRG dichroic mirror 461 and the light detection units 661a and 661b, are configured as a single camera.

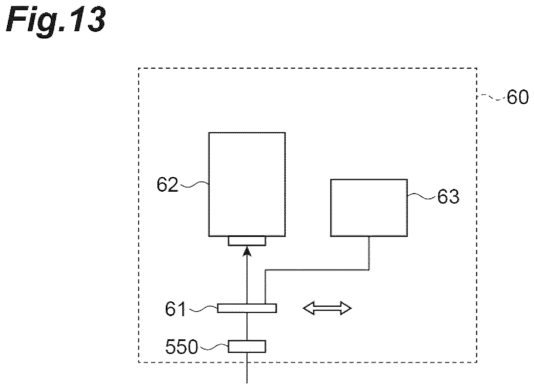

Moreover, the imaging mechanism 60 may have a sensitivity correction filter 550 that flattens the spectral response characteristics of the entire optical system in front of the LRG filter (optical filter) 61, as shown in FIG. 13. By providing the sensitivity correction filter 550, the centroid of wavelengths of light with wavelength widths can be obtained more accurately. In addition, the sensitivity correction filter 550 may be provided between the LRG filter (optical filter) 61 and the camera (image sensor) 62.

Although the case where the computer 70, separate from the imaging unit, derives the wavelength information has been described, the present disclosure is not limited thereto and each process such as the derivation of the wavelength information may be performed by an integrated circuit within a camera.

Reference Signs List

1, 1A Inspection apparatus, 10 Stage, 61 LRG filter (optical filter), 62 Infrared camera (camera, imaging unit, image sensor, first image sensor), 63, 163 Switching unit, 70 Computer (analysis unit), 100 Semiconductor apparatus, 461 LRG dichroic mirror (optical filter), 463 Infrared camera (camera, imaging unit, image sensor, second image sensor)

**Claims**

1. An inspection apparatus for inspecting a semiconductor apparatus, the inspection apparatus comprising:

    a stage configured to hold the semiconductor apparatus;
    an optical filter having a transmission characteristic in which transmittance varies linearly in a predetermined wavelength range and configured to transmit or reflect emitted light generated from the semiconductor apparatus on the basis of the transmission characteristic;
    an imaging unit configured to capture the light transmitted or reflected by the optical filter to output first image data and capture light as emitted light that has arrived without passing through the optical filter to output second image data; and

an analysis unit configured to derive wavelength information about the emitted light on the basis of the first image data and the second image data.

2. The inspection apparatus according to claim 1, wherein the imaging unit has an image sensor configured to capture the light transmitted or reflected by the optical filter and capture the light as the emitted light that has arrived without passing through the optical filter.

3. The inspection apparatus according to claim 1, further comprising a switching unit configured to perform a switching operation between a state in which an optical filter is provided on the light path between the semiconductor apparatus and the imaging unit and a state in which no optical filter is provided.

4. The inspection apparatus according to claim 1,

   wherein the imaging unit has an optical splitting unit configured to split the emitted light into first and second split light paths, a first image sensor arranged on the first split light path, and a second image sensor arranged on the second split light path,
   wherein the optical filter is arranged between the optical splitting unit and the first image sensor on the first split light path,
   wherein the first image sensor captures the light transmitted or reflected by the optical filter to output the first image data, and
   wherein the second image sensor captures the light as the emitted light that has arrived without passing through the optical filter to output the second image data.

5. The inspection apparatus according to claim 1, wherein the analysis unit derives a transmission intensity, which is an intensity of light transmitted through the optical filter, on the basis of the first image data, derives a total intensity of the emitted light on the basis of the second image data, derives a reflection intensity, which is an intensity of light reflected by the optical filter, on the basis of the transmission intensity and the total intensity, and derives wavelength information on the basis of the transmission intensity and the reflection intensity.

6. The inspection apparatus according to claim 1, wherein the analysis unit derives a reflection intensity, which is an intensity of light reflected by the optical filter, on the basis of the first image data, derives a total intensity of the emitted light on the basis of the second image data, derives a transmission intensity, which is an intensity of light transmitted through the optical filter, on the basis of the reflection intensity and the total intensity, and derives wavelength information on the basis of the transmission intensity and the reflection intensity.

7. The inspection apparatus according to claim 5 or 6, wherein the analysis unit derives a difference value between the transmission intensity and the reflection intensity and derives wavelength information on the basis of the difference value.

8. The inspection apparatus according to claim 1, wherein the wavelength information is information indicating a centroid wavelength of the emitted light.

9. The inspection apparatus according to claim 1, wherein the emitted light is light having a wavelength in an infrared wavelength range.

10. An inspection apparatus for inspecting a semiconductor apparatus, the inspection apparatus comprising:

    a stage configured to hold the semiconductor apparatus;
    an optical filter having a transmission characteristic in which transmittance varies linearly in a predetermined wavelength range and configured to transmit or reflect emitted light generated from the semiconductor apparatus on the basis of the transmission characteristic;
    a first image sensor configured to capture the light transmitted through the optical filter to output first image data;
    a second image sensor configured to image light reflected by the optical filter to output second image data; and
    an analysis unit configured to derive wavelength information about the emitted light on the basis of the first image data and the second image data.

11. An inspection method for inspecting a semiconductor apparatus, the inspection method comprising:

transmitting or reflecting emitted light generated from the semiconductor apparatus by an optical filter having a transmission characteristic in which transmittance varies linearly in a predetermined wavelength range, on the basis of the transmission characteristic;
capturing light transmitted or reflected by the optical filter to output first image data;
capturing light as emitted light that has arrived without passing through the optical filter to output second image data; and
deriving wavelength information about the emitted light on the basis of the first image data and the second image data.

12. An inspection method for inspecting a semiconductor apparatus, the inspection method comprising:

transmitting or reflecting emitted light generated from the semiconductor apparatus by an optical filter having a transmission characteristic in which transmittance varies linearly in a predetermined wavelength range, on the basis of the transmission characteristic;
capturing light transmitted through the optical filter to output first image data;
capturing light reflected by the optical filter to output second image data; and
deriving wavelength information about the emitted light on the basis of the first image data and the second image data.

# *Fig.1*

1

# Fig.2

*Fig.3*

Fig.4

(a)                         (b)

802                         902

## Fig.5

D1

WAVELENGTH BAR
(nm)

— 1,700

— 1,400

— 900

## Fig.6

# Fig.7

```
                    ┌─────────────┐
                    │    START    │
                    └─────────────┘
                           │
    ┌──────────────────────────────────────┐
    │       SET SEMICONDUCTOR DEVICE        │── S1
    └──────────────────────────────────────┘
                           │
    ┌──────────────────────────────────────┐
    │   TRANSMIT AND REFLECT INFRARED       │
    │   LIGHT FROM SEMICONDUCTOR            │── S2
    │   DEVICE USING LRG FILTER             │
    └──────────────────────────────────────┘
                           │
    ┌──────────────────────────────────────┐
    │       OUTPUT IMAGE DATA BY            │
    │   CAPTURING LIGHT TRANSMITTED         │── S3
    │       THROUGH LRG FILTER              │
    └──────────────────────────────────────┘
                           │
    ┌──────────────────────────────────────┐
    │       OUTPUT IMAGE DATA BY            │
    │   CAPTURING LIGHT IN STATE            │── S4
    │   IN WHICH THERE IS NO LRG FILTER     │
    └──────────────────────────────────────┘
                           │
    ┌──────────────────────────────────────┐
    │  DERIVE WAVELENGTH INFORMATION        │── S5
    │    ABOUT LIGHT FROM IMAGE DATA        │
    └──────────────────────────────────────┘
                           │
                    ┌─────────────┐
                    │     END     │
                    └─────────────┘
```

## *Fig.8*

(a)

(b)

## Fig.9

(a)

(b)

## *Fig.10*

(a)

(b)

## Fig.11

1A

**Fig.12**

*Fig.13*

## INTERNATIONAL SEARCH REPORT

| International application No. |
|---|
| **PCT/JP2024/001130** |

**A. CLASSIFICATION OF SUBJECT MATTER**

***G01N 21/88***(2006.01)i; ***G01J 3/51***(2006.01)i
FI: G01N21/88 Z; G01J3/51

According to International Patent Classification (IPC) or to both national classification and IPC

**B. FIELDS SEARCHED**

Minimum documentation searched (classification system followed by classification symbols)

G01N21/00-G01N21/958; G01J3/00-G01J3/52; G01J9/00-G01J9/04

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JMEDPlus/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| Y | US 2022/0236109 A1 (THE REGENTS OF THE UNIVERSITY OF CALIFORNIA) 28 July 2022 (2022-07-28) paragraphs [0013]-[0014], [0037], [0040]-[0047], fig. 1 | 1-12 |
| Y | JP 2002-14145 A (HAMAMATSU PHOTONICS KK) 18 January 2002 (2002-01-18) paragraphs [0001], [0005], [0062] | 1-12 |
| Y | JP 2002-511572 A (INTELLIGENT OPTICAL SYSTEMS, INC.) 16 April 2002 (2002-04-16) paragraphs [0020]-[0028], fig. 1-2B | 4, 8 |
| Y | KR 10-1491815 B1 (MEL TELECOM CO., LTD.) 12 February 2015 (2015-02-12) paragraphs [0040]-[0059], fig. 5-7 | 5-7, 10, 12 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **15 February 2024** | **27 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/001130**

| Patent document cited in search report | | | Publication date (day/month/year) | Patent family member(s) | | | Publication date (day/month/year) |
|---|---|---|---|---|---|---|---|
| US | 2022/0236109 | A1 | 28 July 2022 | US | 2020/0378830 | A1 | |
| JP | 2002-14145 | A | 18 January 2002 | (Family: none) | | | |
| JP | 2002-511572 | A | 16 April 2002 | US | 6052179 | A | |
| | | | | column 4, line 30 to column 5, line 56, fig. 1-2B | | | |
| | | | | WO | 1999/053267 | A1 | |
| | | | | EP | 1071920 | A1 | |
| | | | | AU | 4181499 | A | |
| | | | | BR | 9909631 | A | |
| | | | | CN | 1305581 | A | |
| KR | 10-1491815 | B1 | 12 February 2015 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016517970 A
- JP 2015175851 A
- JP 2015203700 A